# EUROPEAN PATENT SPECIFICATION

(11) **EP 3 346 283 B1**
(45) Date of publication and mention of the grant of the patent: **24.11.2021**
(21) Application number: 16841586.7
(22) Date of filing: 23.08.2016
(51) Int. Cl.: G01S 7/03, B29C 45/14, C23C 14/14, G01S 13/93, H01Q 1/42, B60R 19/52

(54) **METHOD OF MANUFACTURING RADAR COVER AND RADAR COVER**
RADARABDECKUNGSHERSTELLUNGSVERFAHREN UND RADARABDECKUNG
PROCÉDÉ DE PRODUCTION D'ENCEINTE DE RECOUVREMENT DE RADAR ET ENCEINTE DE RECOUVREMENT DE RADAR ASSOCIÉE

(30) Priority: 31.08.2015 JP 2015170082
(43) Date of publication of application: 11.07.2018
(73) Proprietor: Faltec Co., Ltd., Kawasaki-shi, Kanagawa 212-0013 (JP)
(72) Inventor: WATANABE, Yuichi, Kawasaki-shi Kanagawa 212-0013 (JP); OHTAKE, Shinichi, Kawasaki-shi Kanagawa 212-0013 (JP)
(74) Representative: Troesch Scheidegger Werner AG
(86) International application number: PCT/JP2016/074483
(87) International publication number: WO 2017/038554

(56) References cited:
- EP-A1- 2 293 382
- JP-A- 2009 286 082
- JP-A- 2011 046 183
- JP-A- 2011 077 888
- JP-A- 2012 153 910
- JP-A- 2014 500 956
- US-A1- 2009 297 880

## Description

### Technical Field

The present invention relates to a method of manufacturing a radar cover, and a radar cover.

### Background Art

In recent years, a radar unit configured to detect an obstacle or the like around a vehicle using a radio wave such as a millimeter wave or the like is mounted on the vehicle. Such a radar unit is disposed inside a radiator grille or an emblem installed on a front surface of the vehicle, and performs transmission and reception of a radio wave passing through the radiator grille. For this reason, in the vehicle including the above-mentioned radar unit, the radiator grille or the emblem needs to be formed to allow transmission of a radio wave while minimizing attenuation of the radio wave.

Meanwhile, the radiator grille or the emblem is an extremely important portion in view of the design of the vehicle since it is disposed on a front surface of the vehicle, and metallic shininess is frequently provided to improve the luxuriousness or texture. In a related art, when plating processing is generally performed to provide metallic shininess, radio waves are not transmitted through a plated layer. For this reason, in recent years, in order to enable transmission of radio waves while providing metallic shininess, a technology of forming a deposition layer of indium (In) or aluminum (Al) through which radio waves can be transmitted is used (see Patent Document 1). Examples of radar covers and of methods of manufacturing radar covers are given in Patent Document 2 and Patent Document 3.

### Document of Related Art

### Patent Document

[Patent Document 1] Japanese Unexamined Patent Application, First Publication No. 2011-46183
[Patent Document 2] Japanese Patent Application JP 2011 077888 A
[Patent Document 3] European Patent Application EP 2 293 382 A1

### Summary of Invention

### Technical Problem

Incidentally, an indium (In) or aluminum (Al) deposition layer is likely to be oxidized. For this reason, a top coat layer needs to be formed to overlap the deposition layer. Such a top coat layer is formed by clear coating using a transparent thermoplastic synthetic resin.

Meanwhile, in recent years, as disclosed in Patent Document 1, a method of forming a recessed portion in a back surface side of a transparent member disposed outside a vehicle, fitting a shiny member having a surface on which shining processing is performed into the recessed portion, and forming a base member to be fixed to the back surface of the transparent member has been proposed.

In such a manufacturing method, the shiny member is disposed in the recessed portion by forming the deposition layer and the top coat layer on the surface of the shiny member and causing the top coat layer to abut an inner surface of the recessed portion of the transparent member. However, the top coat layer may be distorted due to heat when the base member is formed, and therefore, visibility of a shiny region from the outside of the vehicle may be affected by the distortion.

In consideration of the above-mentioned problems, the present invention is directed to provide a radar cover for a vehicle having transmissivity of radio waves and capable of preventing the occurrence of a bad influence on visibility of a shiny region due to heat during manufacture.

### Solution to Problem

As means for solving the above-mentioned problems, the following configurations are employed. The present invention is defined by the claims.

A method of manufacturing a radar cover according to a first aspect of the present invention is a method of manufacturing a radar cover that covers a radar unit configured to determine surrounding conditions of a vehicle, the method including: forming a transparent layer including a recessed portion (a transparent layer forming process); forming a fitting section including a protruding portion to be fitted into the recessed portion (a fitting section forming process); forming a metal shiny film to be disposed between the protruding portion of the fitting section and the recessed portion of the transparent layer and formed of a discontinuous shiny film containing chrome (a shiny film forming process); and fixing the transparent layer and the fitting section to each other in a state where a surface of the metal shiny film on which no coat layer formed of a synthetic resin is formed comes into direct contact with an inner surface of the recessed portion (a fixing process).

In the first aspect, when the shiny film is formed, the shiny film may be formed of pure chrome by sputtering.

In the first aspect, when the shiny film is formed, the shiny film may be formed directly on a surface of the protruding portion.

In the first aspect, when the transparent layer and the fitting section are fixed, when the transparent layer and the fitting section are fixed, insert molding may be used for the transparent layer in which the fitting section is fitted into the recessed portion such that the fitting section is covered with the resin layer.

A radar cover according to a second aspect of the present invention is a radar cover that covers a radar unit configured to determine surrounding conditions of a vehicle, the radar including: a transparent layer including a recessed portion; a fitting section including a protruding portion fitted into the recessed portion and fixed to the transparent layer; and a metal shiny film formed to cover the protruding portion, coming into direct contact with an inner surface of the recessed portion, and formed of a discontinuous shiny film containing chrome, wherein a surface of the shiny film on which no coat layer formed of a synthetic resin is formed comes into direct contact with the inner surface of the recessed portion.

### Effects of Invention

According to aspects of the present invention, a shiny film is formed of a discontinuous shiny film containing chrome. Since such a shiny film contains chrome and has high corrosion resistance, it is not necessary for a top coat layer to be formed. Further, the shiny film comes into directly contact with an inner surface of a recessed portion of a transparent layer without the top coat layer interposed therebetween. For this reason, it is possible to prevent an influence on visibility of a shiny region caused by distortion of the top coat layer due to heat during manufacture. Accordingly, according to the aspects of the present invention, in a radar cover for a vehicle having radio wave transmissivity, it is possible to prevent the occurrence of a bad influence on visibility of the shiny region due to heat during manufacture.

### Brief Description of Drawings

Fig. 1 is a front view of a radiator grille including an emblem according to a first embodiment of the present invention.
Fig. 2 is an enlarged front view of the emblem according to the first embodiment of the present invention.
Fig. 3A is a cross-sectional view of the emblem according to the first embodiment of the present invention.
Fig. 3B is a cross-sectional view of an inner emblem included in the emblem according to the first embodiment of the present invention.
Fig. 4A is a schematic view for explaining a process of manufacturing the emblem according to the first embodiment of the present invention.
Fig. 4B is a schematic view for explaining the process of manufacturing the emblem according to the first embodiment of the present invention.
Fig. 4C is a schematic view for explaining the process of manufacturing the emblem according to the first embodiment of the present invention.
Fig. 4D is a schematic view for explaining the process of manufacturing the emblem according to the first embodiment of the present invention.
Fig. 4E is a schematic view for explaining the process of manufacturing the emblem according to the first embodiment of the present invention.
Fig. 5A is a cross-sectional view of an emblem according to a second embodiment of the present invention.
Fig. 5B is a cross-sectional view of an inner emblem included in the emblem according to the second embodiment of the present invention.
Fig. 6A is a schematic view for explaining a process of manufacturing the emblem according to the second embodiment of the present invention.
Fig. 6B is a schematic view for explaining the process of manufacturing the emblem according to the second embodiment of the present invention.
Fig. 6C is a schematic view for explaining the process of manufacturing the emblem according to the second embodiment of the present invention.
Fig. 6D is a schematic view for explaining the process of manufacturing the emblem according to the second embodiment of the present invention.

### Description of Embodiments

Hereinafter, an embodiment of a method of manufacturing a radar cover and a radar cover according to the present invention will be described with reference to the accompanying drawings. Further, in the following description, in order to exaggerate members to recognizable sizes, the scales of the members may be appropriately varied.

### (First embodiment)

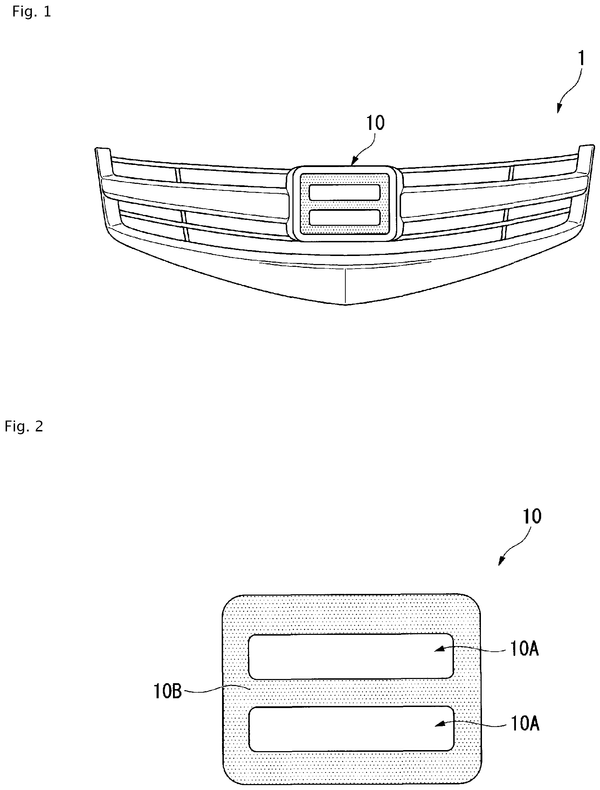

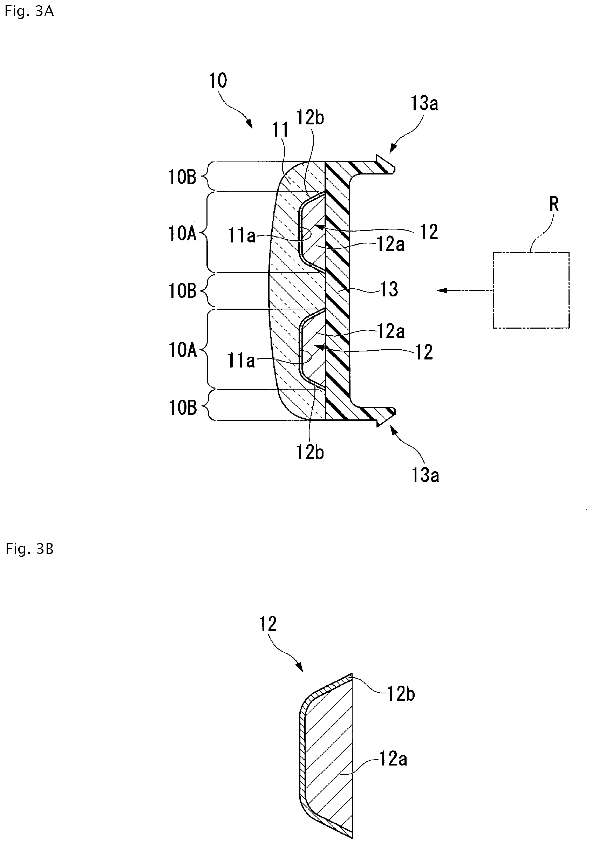

Fig. 1 is a front view of a radiator grille 1 including an emblem 10 constituted by a radar cover according to a first embodiment of the present invention. In addition, Fig. 2 is an enlarged front view of the emblem 10 according to the first embodiment of the present invention. In addition, Fig. 3A is a cross-sectional view of the emblem 10 according to the first embodiment of the present invention. Fig. 3B is a cross-sectional view of an inner emblem 12 included in the emblem 10 according to the first embodiment of the present invention.

The radiator grille 1 is provided on a front surface of a vehicle to cover an opening in communication with an engine compartment of the vehicle. The radiator grille 1 prevents entrance of foreign substances into the engine compartment while securing ventilation to the engine compartment. The emblem 10 is installed at a center of the radiator grille 1 to face a radar unit R disposed in the engine compartment. The radar unit R (see Fig. 3A) has a transmitting unit configured to emit, for example, a millimeter wave, a receiving unit configured to receive a reflected wave, a computing unit configured to perform computation processing, and the like. The radar unit R performs transmission and reception of radio waves passing through the emblem 10, and determines surrounding conditions of the vehicle on the basis of the received radio waves. For example, the radar unit R calculates and outputs the distance to an obstacle, the relative speed of the obstacle, or the like.

The emblem 10 is disposed to cover the radar unit R when seen from a front side of the vehicle. As shown in Fig. 2, the emblem 10 is a part having a shiny region 10A showing a figure, a character, or the like that represents an emblem of a vehicle manufacturer, and a black region 10B that improves visibility of the shiny region 10A when seen from the front side of the vehicle. As shown in Fig. 3A, the emblem 10 includes a transparent member 11 (a transparent layer), the inner emblem 12, and a base member 13 (a resin layer).

The transparent member 11 is a portion disposed at the outermost side of the vehicle and formed of a transparent material having a substantially rectangular shape. The transparent member 11 has a smooth front side surface (a smooth surface) in order to increase visibility of the inner emblem 12 from the outside of the vehicle. In addition, a recessed portion 11a in which the inner emblem 12 is disposed is formed on a surface of a back side of the transparent member 11. In addition, a region in the surface of the back side of the transparent member 11 in which the recessed portion 11a is not formed is a surface attached to the base member 13.

The recessed portion 11a is a portion configured to accommodate the inner emblem 12, and enables the accommodated inner emblem 12 to be three-dimensionally seen from the front side of the vehicle. The recessed portion 11a is formed along a shape of a figure, a character, and the like, of the emblem or the like of the vehicle manufacturer. As the inner emblem 12 is accommodated in the recessed portion 11a, the above-described shiny region 10A is formed.

The transparent member 11 is formed of a transparent synthetic resin such as polycarbonate (PC), polymethyl methacrylate resin (PMMA), or the like which is colorless, and has a thickness of about 1.5 mm to 10 mm. In addition, hard coat processing for preventing scratches or clear coat processing of a urethane-based paint is performed on the surface of the front side of the transparent member 11, if necessary. Further, if the material is a transparent synthetic resin having a scratch resistance, scratch prevention processing of the material is not needed.

As shown in Fig. 3B, the inner emblem 12 includes a base 12a (a fitting section) and a shiny film 12b. The base 12a is formed by injection molding or the like, and, for example, is formed of a synthetic resin such as ABS, PC, PET, or the like. The base 12a has a protruding shape filling the recessed portion 11a of the transparent member 11 and fitted into the recessed portion 11a of the transparent member 11. That is, in the embodiment, the base 12a is formed from the protruding portion itself fitted into the recessed portion 11a of the transparent member 11. The base 12a has a shape configured to bring the shiny film 12b formed on the surface thereof into contact with an inner surface of the recessed portion 11a.

The shiny film 12b is a layer having metallic shininess which is formed on the surface of the front side of the base 12a (the surface of the transparent member 11 side) and is disposed to cover the base 12a. The shiny film 12b is a metal thin film formed of pure chrome (Cr) and having a film thickness of several hundred nm. The shiny film 12b is a discontinuous film having a plurality of cracks (gaps), and configured so that radio waves can pass through these cracks. In addition, the shiny film 12b has extremely high corrosion resistance when compared with a thin film formed of indium (In) or aluminum (Al) because the shiny film 12b is formed of pure chrome (Cr). The shiny film 12b is formed by sputtering using a target formed of, for example, pure chrome (Cr). For example, the base 12a is formed of PC, and a thin film formed of pure chrome (Cr) by sputtering and having a film thickness of 100 to 300 nm (preferably 200 nm) is formed on a surface of the base 12a. The cracks are formed by internal stress remaining in the film during film formation, and the shiny film 12b having radio wave transmissivity is formed by such cracks being formed. In addition, a larger number of cracks can be generated in the thin film due to a difference in heat characteristics (for example, a linear expansion coefficient) between the base 12a and the thin film by cooling the base 12a on which the thin film is formed together with the thin film.

The shiny film 12b has extremely high corrosion resistance, as described above. For this reason, in the embodiment, no coat layer is formed on both sides of the front surface (a surface in contact with the transparent member 11) side of the shiny film 12b and a back surface (a surface in contact with the base 12a) side of the blight film 12b. That is, in the embodiment, a top coat layer and an under coat layer in contact with the shiny film 12b are not provided, and the front surface of the shiny film 12b comes into directly contact with the inner surface of the recessed portion 11a of the transparent member 11 and a back surface of the shiny film 12b comes into directly contact with the base 12a.

Further, in the embodiment, a forming material of the shiny film 12b may not be pure chrome (Cr). For example, the forming material of the shiny film 12b may be an alloy containing chrome (Cr). In addition, in the embodiment, it is essential to provide a configuration in which the top coat layer is not formed on the front surface (the surface of the transparent member 11 side) side of the shiny film 12b. However, the embodiment does not exclude formation of the under coat layer on the back surface (the surface of the base 12a side) side of the shiny film 12b.

The base member 13 is a portion fixed to the back side of the transparent member 11 and formed of a black resin material. The base member 13 has an engaging section 13a protruding toward the engine compartment. The engaging section 13a has a tip portion formed in a claw shape, and the tip portion is locked to, for example, a radiator grille main body. The base member 13 fixed to the surface of the back side of the transparent member 11 in this way can be seen from the outside of the transparent member 11, and the base member 13 forms the above-mentioned black region 10B. In the base member 13, a region except for the shiny region 10A is visible as a black color, and visibility of the shiny region 10A is relatively improved.

The base member 13 is formed of a synthetic resin such as anacrylonitrile-butadiene-styrene (ABS) copolymer synthetic resin, an acrylonitrile-ethylene-styrene (AES) copolymer synthetic resin, acrylonitrile-styrene-acrylate (ASA), polybutylene terephthalate (PBT), colored PC, polyethylene terephthalate (PET), or the like, and a composite resin thereof, and has a thickness of about 0.5 mm to 10 mm.

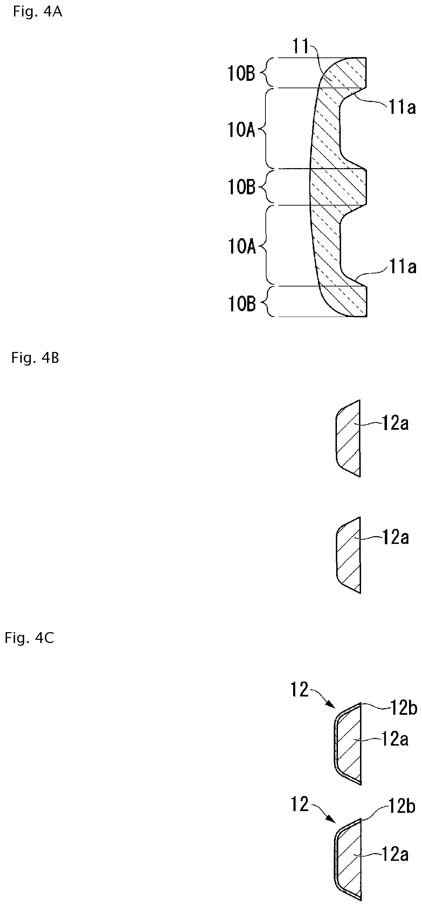

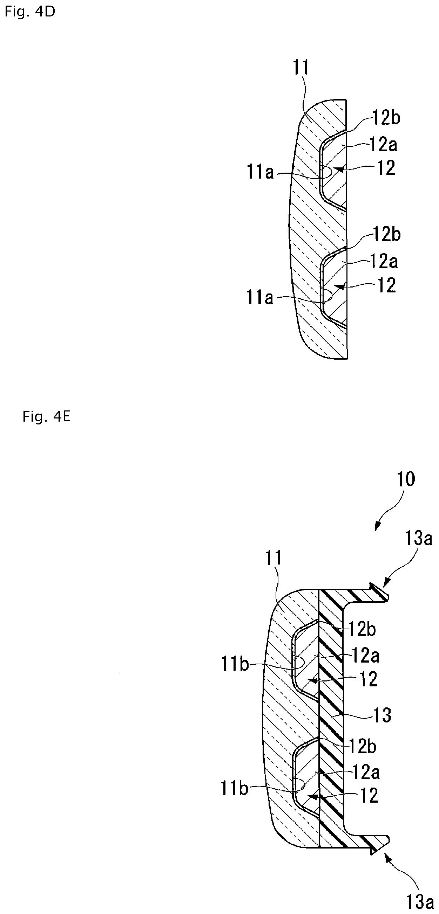

Next, a method of manufacturing the emblem 10 according to the embodiment will be described with reference to Fig. 4.

Figs. 4A to 4E are schematic views for explaining the method of manufacturing the emblem 10 according to the embodiment.

In addition, as shown in Fig. 4A, the transparent member 11 is formed. A process shown in Fig. 4A corresponds to a process of forming a transparent layer of the embodiment. For example, the transparent member 11 is formed by injection molding. The transparent member 11 having the recessed portion 11a can be formed by injection molding. For this reason, it is not necessary to form the recessed portion 11a by a subsequent process. Further, according to necessity, hard coat processing may be performed on the surface side (a surface facing the outside of the vehicle) or the entire surface of the transparent member 11 to improve durability or the like.

Next, as shown in Fig. 4B, the base 12a of the inner emblem 12 is formed. A process shown in Fig. 4B corresponds to a process of forming the fitting section of the embodiment. For example, the base 12a is formed by injection molding. Next, as shown in Fig. 4C, the shiny film 12b is formed on the surface of the base 12a. The process shown in Fig. 4C corresponds to a process of forming a shiny film of the embodiment. The shiny film 12b is formed to have a film thickness in which a plurality of cracks are generated by sputtering in which a thin film formed of pure chrome (Cr) is formed, as described above. The shiny film 12b has radio wave transmissivity because the shiny film 12b has the plurality of cracks. In addition, the shiny film 12b has extremely high corrosion resistance because the shiny film 12b is formed of pure chrome (Cr).

The inner emblem 12 is formed by the process of forming the base 12a shown in Fig. 4B and the process of forming the shiny film 12b shown in Fig. 4C. Further, it is not necessary to perform the process of forming the base 12a shown in Fig. 4B and the process of forming the shiny film 12b shown in Fig. 4C to wait for the process of forming the transparent member 11 shown in Fig. 4A. A manufacturing time of the emblem 10 can be reduced by forming the inner emblem 12 in parallel with the process of forming the transparent member 11 shown in Fig. 4A.

Next, as shown in Fig. 4D, the inner emblem 12 is fitted into the recessed portion 11a of the transparent member 11. Here, a top coat layer is not formed on the surface of the shiny film 12b of the inner emblem 12. For this reason, the shiny film 12b directly comes into contact with the inner surface of the recessed portion 11a.

Next, the base member 13 is formed as shown in Fig. 4E. The process shown in Fig. 4E corresponds to the fixing process of the embodiment. Here, the base member 13 is formed by disposing the transparent member 11, in which the inner emblem 12 is installed in the recessed portion 11a, inside a mold for injection molding, and performing insert molding in which a melted resin is injected toward a back surface side of the transparent member 11 (an insert molding process). The base member 13 is welded to the transparent member 11 by heat during the insert molding and is disposed to cover the inner emblem 12. Accordingly, the shiny film 12b of the inner emblem 12 is fixed to the transparent member 11 together with base 12a in a state in which the shiny film 12b comes into directly contact with the inner surface of the recessed portion 11a.

In the above-mentioned processes, the emblem 10 according to the embodiment is manufactured. According to the method of manufacturing the emblem 10 and the emblem 10 according to the embodiment, the shiny film 12b formed of a discontinuous shiny film containing chrome (Cr) is formed. Since the shiny film 12b contains chrome (Cr) and has high corrosion resistance, it is not necessary to form the top coat layer. Further, the shiny film 12b comes into directly contact with the inner surface of the recessed portion 11a of the transparent member 11 without the top coat layer therebetween. For this reason, it is possible to prevent an influence on visibility of the shiny region 10A caused by distortion of the top coat layer due to heat during manufacture. Accordingly, according to the method of manufacturing the emblem 10 according to the present embodiment, it is possible to prevent the occurrence of a bad influence on visibility of the shiny region 10A due to heat during manufacture, and improvement of a yield can be achieved.

Further, according to the method of manufacturing the emblem 10 of the embodiment, the process of forming the top coat layer can be omitted. Formation of the top coat layer is time-consuming because it is necessary to apply a coat liquid and further wait for the coat liquid to dry. According to the method of manufacturing the emblem 10 of the present invention, since the process of forming the top coat layer can be omitted, it is possible to form the emblem 10 in a short time with a low cost.

In addition, in the method of manufacturing the emblem 10 of the embodiment, the shiny film 12b is formed of pure chrome (Cr) by sputtering. For this reason, the shiny film 12b having extremely high corrosion resistance can be easily formed. In addition, in a case where the shiny film 12b is formed of pure chrome (Cr) by sputtering, a plurality of cracks can be formed in the film by appropriately controlling a thickness of the formed film without performing post-processing. The film thickness of the shiny film 12b is, for example, about 200 nm. For this reason, according to the method of manufacturing the emblem 10 of the present embodiment, the shiny film 12b having radio wave transmissivity can be easily formed.

In addition, in the method of manufacturing the emblem 10 according to the embodiment, the shiny film 12b is directly formed on the surface of the base 12a having a protruding portion. For this reason, the process of forming the under coat layer on the surface of the base 12a can be omitted, and the emblem 10 can be manufactured in a shorter amount of time.

In addition, in the method of manufacturing the emblem 10 according to the embodiment, insert molding is performed for the transparent layer in which the fitting section is fitted into the recessed portion such that the fitting section is covered with the resin layer. Accordingly, the inner emblem 12 is fixed to the transparent member 11. For this reason, the inner emblem 12 can be fixed to the transparent member 11 without using an adhesive agent or the like. Further, in the embodiment, since the top coat layer is not formed between the shiny film 12b and the transparent member 11, an influence on visibility of the shiny region 10A due to heat during insert molding does not occur.

Further, in the embodiment, the configuration in which the inner emblem 12 is configured separately from the base member 13 has been employed. However, the embodiment is not limited thereto, and the inner emblem 12 and the base member 13 may be integrally formed. For example, the inner emblem 12 and the base member 13 can be integrated by forming the protruding portion to have the same shape as the base 12a with regard to the base member 13 and forming the shiny film 12b on the surface of the protruding portion. In this case, for example, the radar cover may be manufactured by welding the base member 13 on which the inner emblem 12 is formed to the transparent member 11.

### (Second embodiment)

Next, a second embodiment of the present invention will be described. Further, in a description of the above-mentioned embodiment, descriptions of the same parts as the above-mentioned first embodiment will be omitted or simplified.

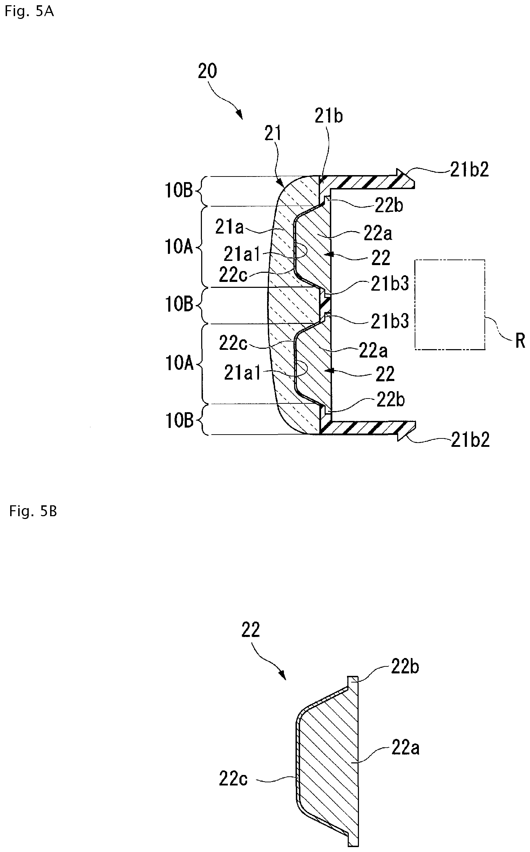

Fig. 5A is a cross-sectional view of an emblem 20 according to the embodiment. Fig. 5B is a cross-sectional view of an inner emblem 22 included in the emblem 20 according to the embodiment. As shown in Fig. 5A, the emblem 20 of the embodiment includes a base section 21 and the inner emblem 22. The base section 21 includes a transparent section 21a (a transparent layer) and a black section 21b.

The transparent section 21a is formed of the same material to have the same shape as the transparent member 11 of the first embodiment. A recessed portion 21a1 in which the inner emblem 22 is disposed is formed on a back side of the transparent section 21a. In addition, a region of a surface of the back side of the transparent section 21a in which the recessed portion 21a1 is not formed is a surface in contact with the black section 21b. The recessed portion 21a1 is a portion configured to accommodate the inner emblem 22 such that the accommodated inner emblem 22 can be three-dimensionally seen from the front side of the vehicle. The recessed portion 21a1 is formed in a figure, a character, and the like, of an emblem or the like of a vehicle manufacturer, like the recessed portion 11a of the first embodiment.

The black section 21b is a layer disposed to be stacked on a surface of the back side of the transparent section 21a, and is a portion that is formed of a black resin material. As shown in Figs. 5A and 5B, the black section 21b is stacked on the transparent section 21a to avoid the recessed portion 21a1. That is, the black section 21b has an opening 21b1 so that the recessed portion 21a1 is exposed. Further, the black section 21b is stacked on the back side of the transparent section 21a such that the opening 21b1 overlaps the recessed portion 21a1. In addition, a step portion 21b3 is formed on an edge portion of the opening 21b1 in the black section 21b. The step portion 21b3 is formed by forming a region of the black section 21b along the opening 21b1 to be thinned with respect to the other region. The step portion 21b3 is a portion to which a flange 22b (to be described below) of the inner emblem 22 is fixed. In addition, the black section 21b has engaging sections 21b2 protruding toward an engine compartment. Each of the engaging sections 21b2 has a tip portion formed in a claw shape, and the tip portion is locked to, for example, a radiator grille main body. The black section 21b disposed to be stacked on the surface of the back side of the transparent section 21a in this way can be seen from the outside of the transparent section 21a, and forms the above-described black region 10B. That is, a region of the black section 21b except for the shiny region 10A is recognized as a black color, and visibility of the shiny region 10A is relatively improved.

The black section 21b is formed of a synthetic resin such as an acrylonitrile-butadiene-styrene (ABS) copolymer synthetic resin, an acrylonitrile-ethylene-styrene (AES) copolymer synthetic resin, acrylonitrile-styrene-acrylate (ASA), polybutylene terephthalate (PBT), colored PC, polyethylene terephthalate (PET), or the like, or a composite resin thereof, and has a thickness of about 0.5 mm to 10 mm.

The base section 21 having the transparent section 21a and the black section 21b is formed through two color molding. For example, the transparent section 21a is formed in advance, and the black section 21b is formed on the surface of the back side of the transparent section 21a formed in advance to avoid the recessed portion 21a1. The base section 21 in which the transparent section 21a and the black section 21b are integrated can be easily formed through two color molding. However, the method of forming the base section 21 is not limited to the two color molding. For example, the base section 21 can also be formed by separately forming the transparent section 21a and the black section 21b through injection molding, and fixing the transparent section 21a and the black section 21b, which are separated from each other, using an adhesive agent or through welding.

As shown in Fig. 5B, the inner emblem 22 includes a base 22a, the flange 22b, and a shiny film 22c. The base 22a and the flange 22b are integrally formed by injection molding or the like, and, for example, are formed of a synthetic resin such as ABS, PC, PET, or the like. The base 22a is a protruding portion disposed in the recessed portion 21a1 and configured to fill the recessed portion 21a1. The base 22a has a shape configured to bring the shiny film 22c formed on the surface in contact with an inner wall surface of the recessed portion 21a1. The flange 22b is formed to surround the base 22a and forms an edge portion of the inner emblem 22. The flange 22b is a portion that comes into contact with the step portion 21b3 formed on the black section 21b. Further, as shown in Fig. 5B, the base 22a is formed to protrude closer to the transparent section 21a than the flange 22b. Further, in the embodiment, a fitting section is formed by the base 22a and the flange 22b, and the base 22a corresponds to the protruding portion.

The shiny film 22c is a layer formed on a surface of a front side (a surface of the transparent section 21a side) of the base 22a and having metallic shininess. The shiny film 22c is a metal thin film formed of pure chrome (Cr) and having a film thickness of several hundred nm, like the shiny film 12b of the first embodiment. That is, the shiny film 22c is a discontinuous film having a plurality of cracks (gaps), and has a configuration such that radio wave can pass through these cracks. In addition, since the shiny film 22c is formed of pure chrome (Cr), corrosion resistance is extremely high when compared with a thin film formed of indium (In) or aluminum (Al). The shiny film 22c may be formed through sputtering using a target formed of, for example, pure chrome (Cr), like the shiny film 12b of the first embodiment.

The shiny film 22c has extremely high corrosion resistance, as described above, and no coat layer is formed on both surfaces of the front surface (the surface in contact with the transparent section 21a) and the back surface (the surface in contact with the base 22a) of the shiny film 22c. That is, in the embodiment, neither the top coat layer nor the under coat layer in contact with the shiny film 22c is formed. For this reason, the front surface of the shiny film 22c comes into directly contact with the inner surface of the recessed portion 21a1 of the transparent section 21a, and the back surface of the shiny film 22c comes into directly contact with the base 22a.

Further, in the embodiment, a forming material of the shiny film 22c may not be pure chrome (Cr). For example, the forming material of the shiny film 22c may be an alloy containing chrome (Cr). In addition, in the embodiment, the configuration in which the top coat layer is not formed on the front surface (the surface of the transparent section 21a side) side of the shiny film 22c is necessary. However, the embodiment does not exclude formation of the under coat layer on the back surface (the surface of the base 22a side) side of the shiny film 22c.

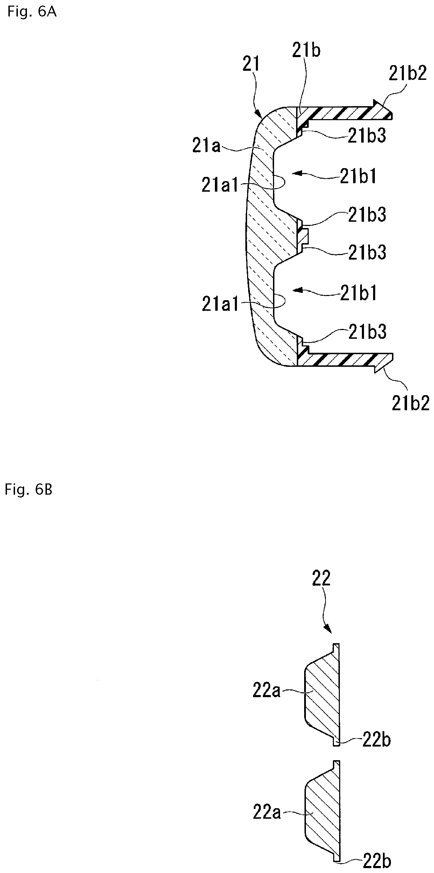

Next, a method of manufacturing the emblem 20 according to the embodiment will be described. Figs. 6A to 6D are views schematically showing a process of manufacturing the emblem 20 according to the embodiment. First, as shown in Fig. 6A, formation of the base section 21 is performed. For example, first, the transparent section 21a is formed using a first mold (not shown) through injection molding, and the black section 21b is then stacked on the transparent section 21a using a second mold (not shown) through injection molding. That is, the transparent section 21a formed of a resin material and the black section 21b formed of a resin material having a different color from the transparent section 21a are integrally formed through two color molding. Here, when the transparent section 21a is formed by the first mold, the recessed portion 21a1 is formed in the transparent section 21a. In addition, when the black section 21b is formed by the second mold, the black section 21b is formed to avoid the recessed portion 21a1. Further, in the embodiment, the process of forming the transparent section 21a corresponds to the process of forming the transparent layer.

Next, as shown in Fig. 6B, the base 22a and the flange 22b of the inner emblem 22 are integrally formed through injection molding. The process shown in Fig. 6B corresponds to the process of forming the fitting section. Here, for example, a welding rib (a protrusion formed of a resin) may be formed on a surface of the flange 22b coming into contact with the transparent section 21a. The welding rib is a portion formed, for example, in an annular shape to surround the base 22a, and is melted to weld the transparent section 21a and the flange 22b in a subsequent process.

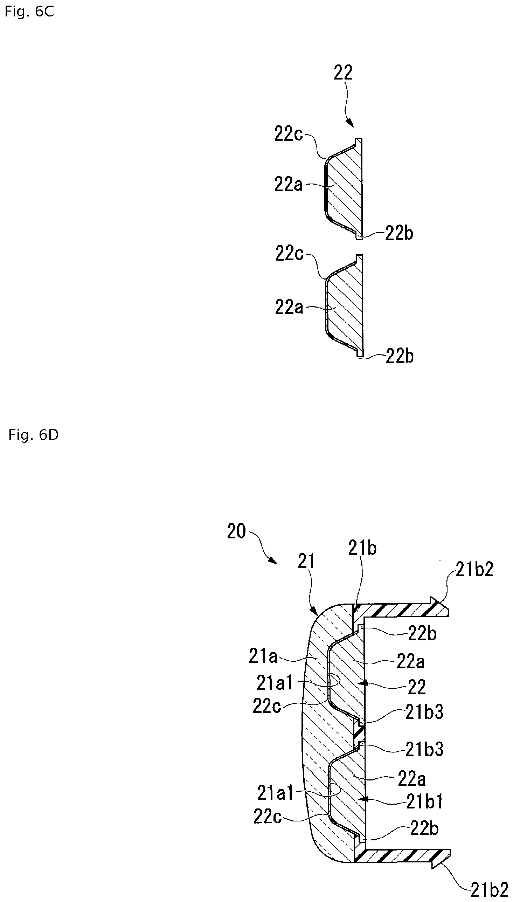

Next, as shown in Fig. 6C, the shiny film 22c is formed on a surface of the front side of the base 22a. A process shown in Fig. 6C corresponds to a process of forming a shiny film. Further, since a surface of a front side of the flange 22b (a surface of a front side of the vehicle) comes into contact with the black section 21b, the flange 22b cannot be seen from the outside through the transparent section 21a. For this reason, it is not necessary to form the shiny film 22c on the surface of the front side of the flange 22b. Accordingly, when the shiny film 22c is formed, the surface of the flange 22b may be masked. However, the shiny film 22c is thin and delaminated due to heat in a subsequent process in which the transparent section 21a and the flange 22b are welded. Accordingly, it is convenient to also form the shiny film 22c on the surface of the front side of the flange 22b without performing the masking.

The inner emblem 22 is formed by the process of forming the base 22a and the flange 22b shown in Fig. 6B and the process of forming the shiny film 22c shown in Fig. 6C. Further, it is not necessary to perform the process of forming the base 22a and the flange 22b shown in Fig. 6B and the process of forming the shiny film 22c shown in Fig. 6C to wait for the process of forming the base section 21 shown in Fig. 6A. A manufacturing time of the emblem 20 can be reduced by forming the inner emblem 22 in parallel with the process of forming the base section 21 shown in Fig. 6A.

Next, as shown in Fig. 6D, the inner emblem 22 is disposed to be accommodated in the recessed portion 21a1 of the base section 21. Here, as shown in Fig. 6D, the inner emblem 22 is disposed in the recessed portion 21a1 such that the flange 22b of the inner emblem 22 comes into contact with the step portion 21b3 provided in the black section 21b of the base section 21. Next, the surface of the flange 22b is melted, and the inner emblem 22 is welded to the black section 21b.

Here, for example, the inner emblem 22 is welded to the black section 21b through an ultrasonic welding method, a laser transmission welding method, or the like. When the ultrasonic welding method is used, for example, ultrasonic vibrations are applied to the inner emblem 22. Frictional heat is generated at an interface between the flange 22b and the black section 21b due to the vibrations, and a surface layer of the flange 22b is melted by the frictional heat. Then, the inner emblem 22 is welded to the black section 21b by being cooled. In addition, in the laser transmission welding method, for example, the inner emblem 22 is formed of a material through which a laser beam passes. Further, a surface layer of the flange 22b is melted by irradiating the surface of the flange 22b with a laser beam from the back side of the inner emblem 22. Then, the inner emblem 22 is welded to the black section 21b by being cooled.

The shiny film 22c of the inner emblem 22 is fixed to the transparent section 21a while in direct contact with the inner surface of the recessed portion 21a1 by welding the flange 22b of the inner emblem 22 to the base section 21. That is, in the embodiment, the process of fixing the inner emblem 22 to the base section 21 shown in Fig. 6D corresponds to a fixing process.

After that, the emblem 20 according to the embodiment is completed by performing hard coat processing on the surface of the transparent section 21a if needed. According to the method of manufacturing the emblem 20 and the emblem 20 of the embodiment, the shiny film 22c having a discontinuous shiny film containing chrome (Cr) is formed. Since the shiny film 22c contains chrome (Cr) and has high corrosion resistance, it is not necessary to form the top coat layer. Further, the shiny film 22c directly comes into contact with the inner surface of the recessed portion 21a1 of the transparent section 21a without the top coat layer therebetween. For this reason, it is possible to prevent an influence on visibility of the shiny region 10A caused by distortion of the top coat layer due to heat during manufacture. Accordingly, according to the method of manufacturing the emblem 20 of the embodiment, like the first embodiment, it is possible to prevent the occurrence of a bad influence on visibility of the shiny region 10A due to heat during manufacture, and improvement of yield can be achieved.

Further, according to the method of manufacturing the emblem 20 according to the embodiment, the black section 21b is stacked on the transparent section 21a to avoid the recessed portion 21a1 of the transparent section 21a. For this reason, after the black section 21b is stacked on the transparent section 21a, the inner emblem 22 can be disposed in the recessed portion 21a1. Accordingly, it is not necessary to provide the inner emblem 22 to be sandwiched between the transparent section 21a and the black section 21b, and it is not necessary to perform insert molding. In addition, fixing of the inner emblem 22 to the black section 21b can be performed through a welding method by ultrasonic waves or laser beams. According to these methods, since only a local heat input to only the fixed place is necessary, a thermal load to the inner emblem 22 can be largely reduced when compared with the case in which the insert molding is performed. Accordingly, according to the method of manufacturing the emblem 20 of the embodiment, a thermal load to the inner emblem 22 is largely reduced, deterioration of the inner emblem 22 due to exposure to a high temperature is suppressed, and improvement of yield of the emblem 20 can be achieved.

Hereinabove, while the preferred embodiments have been described with reference to the accompanying drawings, it is needless to say that the present invention is defined by the claims and is not limited to the above-mentioned embodiments. All shapes, combinations, and the like of the components described in the above-mentioned embodiments are exemplary, and various modifications may be made thereto on the basis of design requirements without departing from the scope of the present invention. as set forth by the claims.

For example, in the first embodiment, the configuration in which, after the shiny film 12b is formed on the surface of the base 12a during manufacture of the emblem 10, the base 12a is fitted into the recessed portion 11a has been described. However, the present invention is not limited thereto, and may include a configuration in which the shiny film 12b may be formed on the inner surface of the recessed portion 11a and the base 12a is then fitted thereinto.

In addition, in the second embodiment, the configuration in which, after the shiny film 22c is formed on the surface of the base 22a during manufacture of the emblem 20, the base 22a is fitted into the recessed portion 21a1 has been described. However, the present invention is not limited thereto, and may also employ a configuration in which the shiny film 22c is formed on the inner surface of the recessed portion 21a1 and the base 22a is then fitted thereinto.

### Description of Reference Signs

- 10: Emblem (radar cover)
- 10A: Shiny region
- 10B: Black region
- 11: Transparent member (transparent layer)
- 11a: Recessed portion
- 12: Inner emblem
- 12a: Base (protruding portion)
- 12b: Shiny film
- 13: Base member
- 13a: Engaging section
- 20: Emblem (radar cover)
- 21: Base section
- 21a: Transparent section (transparent layer)
- 21a1: Recessed portion
- 21b: Black section
- 21b1: Opening
- 21b2: Engaging section
- 21b3: Step portion
- 22: Inner emblem
- 22a: Base (protruding portion)
- 22b: Flange
- 22c: Shiny film

## Claims

1. A method of manufacturing a radar cover (10, 20) that covers a radar unit (R) configured to determine surrounding conditions of a vehicle, the method comprising:
forming a transparent layer (11, 21a) including a recessed portion (11a, 21a1); and
forming a fitting section (12, 22) including a protruding portion (12a, 22a) to be fitted into the recessed portion (11a, 21a1),
**characterized by**
forming a metal shiny film (12b) to be disposed between the protruding portion (12a, 22a) of the fitting section (12, 22) and the recessed portion (11a, 21a1) of the transparent layer (11, 21a) and formed of a discontinuous shiny film containing chrome; and
fixing the transparent layer (11, 21a) and the fitting section (12, 22) to each other in a state where a surface of the shiny film (12b) on which no coat layer formed of a synthetic resin is formed comes into direct contact with an inner surface of the recessed portion (11a, 21a1).

2. The method of manufacturing a radar cover (10, 20) according to claim 1, wherein
when the shiny film (12b) is formed, a film containing chrome is formed by sputtering, and the shiny film (12b) is formed by cracks being formed by internal stress remaining in the film during film formation.

3. The method of manufacturing a radar cover (10, 20) according to claim 1 or 2, wherein
when the shiny film (12b) is formed, the shiny film (12b) is formed of pure chrome by sputtering.

4. The method of manufacturing a radar cover (10, 20) according to any one of claims 1 to 3, wherein
when the shiny film (12b) is formed, the shiny film (12b) is formed directly on a surface of the protruding portion (12a, 22a).

5. The method of manufacturing a radar cover (10, 20) according to any one of claims 1 to 4, wherein
when the transparent layer (11, 21a) and the fitting section (12, 22) are fixed, insert molding is used for the transparent layer (11, 21a) in which the fitting section (12, 22) is fitted into the recessed portion (11a, 21a1) such that the fitting section (12, 22) is covered with the resin layer.

6. The method of manufacturing a radar cover (20) according to any one of claims 1 to 4, wherein
when the fitting section (22) is formed, the fitting section (22) is formed of a base (22a) and a flange (22b),
before the transparent layer (11, 21a) and the fitting section (22) are fixed to each other, a resin layer having a different color from the transparent layer (21a) is formed on the transparent layer (21a) so as to avoid the recessed portion (21a1), and
when the transparent layer (21a) and the fitting section (22) are fixed to each other, the transparent layer-side of the flange (22b) is welded to the resin layer.

7. A radar cover (10, 20) that covers a radar unit (R) configured to determine surrounding conditions of a vehicle, the radar cover (10, 20) comprising:
a transparent layer (11, 21a) including a recessed portion (11a, 21al); and
a fitting section (12, 22) including a protruding portion (12a, 22a) fitted into the recessed portion (11a, 21a1) and fixed to the transparent layer (11, 21a),
**characterized by**
a metal shiny film (12b) formed to cover the protruding portion (12a, 22a), coming into direct contact with an inner surface of the recessed portion (11a, 21a1), and formed of a discontinuous shiny film containing chrome, wherein a surface of the shiny film (12b) on which no coat layer formed of a synthetic resin is formed comes into direct contact with the inner surface of the recessed portion (11a, 21a1).

8. The radar cover (20) according to claim 7, wherein
the fitting section (22) is formed of a base (22a) and a flange (22b),
a resin layer having a different color from the transparent layer (21a) is formed on the transparent layer (21a) so as to avoid the recessed portion (21a1), and
the transparent layer-side of the flange (22b) is welded to the resin layer.

## Patentansprüche

1. Verfahren zum Herstellen einer Radarabdeckung (10, 20), welche eine Radareinheit (R) abdeckt, welche dazu konfiguriert ist, Umgebungsbedingungen eines Fahrzeugs zu bestimmen, wobei das Verfahren Folgendes umfasst:
Bilden einer transparenten Schicht (11, 21a), welche einen vertieften Teil (11a, 21a1) beinhaltet; und
Bilden eines passenden Abschnitts (12, 22), welcher einen vorstehenden Teil (12a, 22a) beinhaltet, welcher in den vertieften Teil (11a, 21a1) hineinpasst,
**gekennzeichnet durch**
Bilden eines glänzenden Metallüberzugs (12b), welcher zwischen dem vorstehenden Teil (12a, 22a) des passenden Abschnitts (12, 22) und dem vertieften Teil (11a, 21a1) der transparenten Schicht (11, 21a) anzuordnen ist und aus einem unterbrochenen glänzenden Überzug gebildet ist, welcher Chrom enthält; und
aneinander Befestigen der transparenten Schicht (11, 21a) und des passenden Abschnitts (12, 22) in einem Zustand, bei dem eine Fläche des glänzenden Überzugs (12b), auf welcher keine Deckschicht aus einem synthetischen Harz gebildet ist, in direkten Kontakt mit einer inneren Fläche des vertieften Teils (11a, 21a1) kommt.

2. Verfahren zum Herstellen einer Radarabdeckung (10, 20) nach Anspruch 1, wobei
ein Überzug, welcher Chrom enthält, durch Sputtern gebildet wird, wenn der glänzende Überzug (12b) gebildet wird, und wobei der glänzende Überzug (12b) durch Risse gebildet ist, welche durch innere Spannung gebildet werden, welche während des Bildens des Überzugs in dem Überzug verbleibt.

3. Verfahren zum Herstellen einer Radarabdeckung (10, 20) nach Anspruch 1 oder 2, wobei
der glänzende Überzug (12b) durch Sputtern aus purem Chrom gebildet wird, wenn der glänzende Überzug (12b) gebildet wird.

4. Verfahren zum Herstellen einer Radarabdeckung (10, 20) nach einem der Ansprüche 1 bis 3, wobei
der glänzende Überzug (12b) direkt auf einer Fläche des vorstehenden Teils (12a, 22a) gebildet wird, wenn der glänzende Überzug (12b) gebildet wird.

5. Verfahren zum Herstellen einer Radarabdeckung (10, 20) nach einem der Ansprüche 1 bis 4, wobei
für die transparente Schicht (11, 21a) ein Umspritzen verwendet wird, bei welchem der passende Abschnitt (12, 22) in den vertieften Teil (11a, 21a1) eingepasst wird, so dass der passende Abschnitt (12, 22) mit der Harzschicht bedeckt wird, wenn die transparente Schicht (11, 21a) und der passende Abschnitt (12, 22) befestigt werden.

6. Verfahren zum Herstellen einer Radarabdeckung (20) nach einem der Ansprüche 1 bis 4, wobei
der passende Abschnitt (22) aus einer Basis (22a) und einem Flansch (22b) gebildet wird, wenn der passende Abschnitt (22) gebildet wird,
eine Harzschicht, welche eine unterschiedliche Farbe aufweist als die transparente Schicht (21a), auf der transparenten Schicht (21a) gebildet wird, um den vertieften Teil (21al) zu vermeiden, bevor die transparente Schicht (11, 21a) und der passende Abschnitt (22) aneinander befestigt werden, und
die Seite des Flanschs (22b) mit der transparenten Schicht an die Harzschicht geschweißt wird, wenn die transparente Schicht (21a) und die passende Schicht (22) aneinander befestigt werden.

7. Radarabdeckung (10, 20), welche eine Radareinheit (R) abdeckt, welche dazu konfiguriert ist, Umgebungsbedingungen eines Fahrzeugs zu bestimmen, wobei die Radarabdeckung (10, 20) Folgendes umfasst:
eine transparente Schicht (11, 21a), welche einen vertieften Teil (11a, 21al) beinhaltet; und
einen passenden Abschnitt (12, 22), welcher einen vorstehenden Teil (12a, 22a) beinhaltet, welcher in den vertieften Teil (11a, 21a1) hineinpasst und an der transparenten Schicht (11, 21a) befestigt ist,
**gekennzeichnet durch**
einen glänzenden Metallüberzug (12b), welcher dazu gebildet ist, den vorstehenden Teil (12a, 22a) abzudecken, welcher in direkten Kontakt mit einer inneren Fläche des vertieften Teils (11a, 21a1) kommt und aus einem unterbrochenen glänzenden Überzug gebildet ist, welcher Chrom enthält, wobei eine Fläche des glänzenden Überzugs (12b), auf welcher keine Deckschicht aus einem synthetischen Harz gebildet ist, in direkten Kontakt mit der inneren Fläche des vertieften Teils (11a, 21al) kommt.

8. Radarabdeckung (20) nach Anspruch 7, wobei
der passende Abschnitt (22) aus einer Basis (22a) und einem Flansch (22b) gebildet ist,
eine Harzschicht, welche eine unterschiedliche Farbe aufweist als die transparente Schicht (21a), auf der transparenten Schicht (21a) gebildet ist, um den vertieften Teil (21al) zu vermeiden, und
die Seite des Flanschs (22b) mit der transparenten Schicht an die Harzschicht geschweißt ist.

## Revendications

1. Procédé pour fabriquer un couvercle de radar (10, 20) recouvrant une unité de radar (R) configurée pour déterminer les conditions environnantes d'un véhicule, le procédé consistant à :
- former une couche transparente (11, 21a) comprenant une partie renfoncée (11a, 21a1) ; et
- former une section de raccord (12, 22) comprenant une partie en saillie (12a, 22a) destinée à venir s'engager dans la partie renfoncée (11a, 21a1),
**caractérisé par**
- la formation d'un film métallique brillant (12b) destiné à être agencé entre la partie en saillie (12a, 22a) de la section de raccord (12, 22) et la partie renfoncée (11a, 21a1) de la couche transparente (11, 21a) et constitué d'un film brillant discontinu contenant du chrome ; et
- la fixation de la couche transparente (11, 21a) et de la section de raccord (12, 22) ensemble dans un état dans lequel une surface du film brillant (12b) sur laquelle il n'y a aucune couche de revêtement en résine synthétique entre en contact direct avec une surface intérieure de la partie renfoncée (11a, 21a1).

2. Procédé pour fabriquer un couvercle de radar (10, 20) selon la revendication 1, dans lequel, lorsque le film brillant (12b) est formé, il est formé par pulvérisation un film contenant du chrome, et dans lequel le film brillant (12b) est formé par des fissures formées par la contrainte interne restant dans le film pendant la formation du film.

3. Procédé pour fabriquer un couvercle de radar (10, 20) selon la revendication 1 ou 2, dans lequel, lorsque le film brillant (12b) est formé, le film brillant (12b) est constitué de chrome pur par pulvérisation.

4. Procédé pour fabriquer un couvercle de radar (10, 20) selon l'une des revendications 1 à 3, dans lequel lorsque le film brillant (12b) est formé, le film brillant (12b) est formé directement sur une surface de la partie en saillie (12a, 22a).

5. Procédé pour fabriquer un couvercle de radar (10, 20) selon l'une des revendications 1 à 4, dans lequel lorsque la couche transparente (11, 21a) et la section de raccord (12, 22) sont fixées, il est utilisé un moulage d'insert pour la couche transparente (11a, 21a), dans lequel la section de raccord (12, 22) est montée dans la partie renfoncée (11a, 21a1) de façon à ce que la section de raccord (12, 22) soit couverte par la couche de résine.

6. Procédé pour fabriquer un couvercle de radar (20) selon l'une des revendications 1 à 4, dans lequel
- lorsque la section de raccord (22) est formée, la section de raccord (22) est constituée d'une base (22a) et d'une bride (22b),
- avant que la couche transparente (11, 21a) et la section de raccord (22) soient fixées l'une à l'autre, il est formé sur la couche transparente (21a) une couche de résine d'une couleur différente de la couche transparente (21a) de façon à éviter la partie renfoncée (21a1), et
- lorsque la couche transparente (21a)et la section de raccord (22) sont fixées l'une à l'autre, le côté couche transparente de la bride (22b) est soudé à la couche de résine.

7. Couvercle de radar (10, 20) recouvrant une unité de radar (R) configurée pour déterminer les conditions environnantes d'un véhicule, le couvercle de radar (10, 20) comprenant :
- une couche transparente (11, 21a) comprenant une partie renfoncée (11a, 21a1) et une section de raccord (12, 22) comprenant une partie en saillie (12a, 22a) installée dans la partie renfoncée (11a, 21a1) et fixée à la couche transparente (11, 21a),
**caractérisé par**
- un film métallique brillant (12b) formé pour couvrir la partie en saillie (12a, 22a), venant en contact direct avec une surface intérieure de la partie renfoncée (11a, 21a1), et constitué d'un film brillant discontinu contenant du chrome, une surface du film brillant (12b) sur laquelle il n'est formé aucune couche de revêtement constituée d'une résine synthétique venant en contact direct avec la surface intérieure de la partie renfoncée (11a, 21a1).

8. Couvercle de radar (20) selon la revendication 7, dans lequel
- la section de raccord (22) est constituée d'une base (22a) et d'une bride (22b),
- une couche de résine ayant une couleur différente de la couche transparente (21a) est formée sur la couche transparente (21a) de façon à éviter la partie renfoncée (21a1), et
- le côté couche transparente de la bride (22b) est soudée à la couche de résine.
